Europäisches Patentamt

European Patent Office

Office européen des brevets

(19)

(11) Publication number: **0 206 620 B1**

# (12) EUROPEAN PATENT SPECIFICATION

(45) Date of publication of patent specification: **26.08.92**  (51) Int. Cl.⁵: **H02G 5/02, H01R 43/02**

(21) Application number: **86304394.9**

(22) Date of filing: **09.06.86**

(54) **Self-heating, self-soldering bus bar.**

(30) Priority: **18.06.85 US 745936**

(43) Date of publication of application:
**30.12.86 Bulletin 86/52**

(45) Publication of the grant of the patent:
**26.08.92 Bulletin 92/35**

(84) Designated Contracting States:
**AT BE CH DE FR GB IT LI NL SE**

(56) References cited:
**WO-A-84/02098**
**US-A- 4 001 490**
**US-A- 4 256 945**

(73) Proprietor: **METCAL INC.**
**3704 Haven Court**
**Menlo Park California 94025(US)**

(72) Inventor: **Krumme, John F.**
**87 Upenuf Road**
**Woodside California 94062(US)**
Inventor: **Cowell, Mark J.**
**982 Lupin Way**
**San Carlos California 94070(US)**

(74) Representative: **Hayward, Denis Edward Peter et al**
**Lloyd Wise, Tregear & Co. Norman House**
**105-109 Strand**
**London WC2R 0AE(GB)**

## Description

The present invention relates to an apparatus and method for simultaneously making, by soldering, multiple electrical circuit connections arrayed in a row along a common carrier or bus bar, regardless of whether the bus bar is itself electrically conductive or non-conductive.

Several problems exist with present methods available to heat bus bar terminals for soldering to printed circuit boards and other electrical applications. A relatively large copper bus is necessary to carry large amounts of current, which constitutes an extremely good electrical and thermal conductor. The heat sink effect which results from this large conductor prevents the bus pins from being uniformly heated.

Present conduction and wave solder techniques are unsatisfactory. Conduction soldering requires a high temperature soldering iron due to the large thermal heat sink of the bus. The temperature gradient which forms across the pins causes improper solder joints especially at the cooler base of the pin. If the bus bar is heated by wave soldering uniform heating is attained across the pins and a good solder joint is formed; however, uniform heating is also attained across the entire length of the bus causing thermal expansion of the bus. When the bus cools and contracts, the board to which it is soldered warps undesirably.

Conventional direct heating which can minimize board warpage also requires that each pin be individually heated which is time consuming and prevents removal of the bus which can only be accomplished by desoldering all pins at once. Also direct conduction heating is applied to the tip of the bus pins and results in non-uniform pin heating and often the base of the pins will not achieve solder melt temperature due to the large thermal sink of the bar.

The present invention eliminates the problems of thermal expansion in thermally conductive bus bars and also eliminates the multiple step soldering of both conductive and non-conductive bus bars.

In the prior art, US-A-4256945 discusses the theory of auto-regulated heating utilising the skin effect associated with the flow of a constant high frequency alternating current in a ferromagnetic material and the change that takes place as the Curie temperature of the material is approached. It proposes, as a practical embodiment, a soldering iron incorporating such auto-regulated heating.

WO-A-8402098 describes a variety of connectors embodying auto-regulated heating one amongst which is a proposal for a multi-pin electrical connector, with push-fit contact pins, that is provided with releasable securing means to prevent the plug and socket connector bodies from separating unintentionally. This mechanical securing means comprises a pair of pins on one body which enter a pair of receptors on the other body and the mated pins and receptors constitute auto-regulating heaters employing the Curie temperature effect of current flow in ferromagnetic material and serving to melt solder contained in the receptors to unite the connector bodies. Separation is later possible by reheating to re-melt the solder.

According to the invention, there is provided an electrical terminal connection soldering assembly for making multiple soldered terminal connections in a row, comprising an elongated bus bar carrying a row of connector pins spaced along it which pins are oriented transversely to the longitudinal axis of the bus bar, characterised in that each connector pin in the row is a self-contained heater including a ferromagnetic electrical resistance heating element and provided with its own respective electrical energising means which produces a flow of heating current in the ferromagnetic heating element when connected to a substantially constant high frequency alternating current supply thereby to raise each heater pin to a sufficient temperature to melt solder which temperature is reached before the Curie temperature of the ferromagnetic material is effective to curtail further temperature increase.

The invention further provides a method for mounting a bus bar on a circuit board by connecting a row of pins along the bus bar to respective contacts on the board, characterised by:

forming the pins of said bus bar at least partly of a ferromagnetic material,

encircling each of said pins with a respective coil of an insulated current carrier,

electrically connecting said coils in circuit,

disposing respective amounts of solder in cooperative association with the distal ends of said pins and respective receptor holes in the circuit board,

applying pressure tending to urge said pins into said receptor holes,

energising said coils with a high frequency alternating electric current thereby to induce current flow in the ferromagnetic material of each pin sufficient to raise the temperature of the pins to solder melt temperature,

allowing the molten solder to flow into each receptor hole and around the respective pin as the pin enters the hole,

terminating the flow of current through the coils before the temperature of the main body of the bus bar is raised substantially, and

allowing the solder to cool and solidify.

According to the preferred embodiment, a bus bar utilises inductively energised ferromagnetic thermal heaters to achieve rapid uniform heating of bus bar pins without heating the bus. The ferromagnetic thermal heaters are integrated into each pin of the bus bar and are connected in series to a constant current high frequency power source.

When power is applied from the high frequency power source to the heaters the heaters raise the temperature of the pins to solder melt temperature. The solder which has previously been disposed between the pins and the holes into which the pins are to be mounted melts and flows around the pins and holes. The power is switched off, the pins cool and the solder hardens, mounting the bus bar in place.

Rapid heating of the pins is necessary to allow the pins to achieve solder melt temperature before the main portion of the bus bar heats significantly. To allow rapid heating of the pins the inductive heaters are extremely light weight, and to prevent overheating, ferromagnetic materials known for their thermal/resistive interdependent properties, are used to comprise the pins of the bus bar. Ferromagnetic materials have a high electrical resistivity when cool but change their resistivity at or about a particular temperature known as the Curie temperature.

When a current passes through a ferromagnetic material the high resistance of the ferromagnetic material causes the generation of resistive heat. When the resistance of the ferromagnetic material drops at the Curie temperature, the amount of heat generated diminishes for a given power input. This tends to prevent further heating once the Curie temperature of the material has been reached.

However, whereas the preferred embodiment contemplates an electrically-conductive bus bar which becomes part of the electrical assembly after soldering, the invention is also applicable with benefit to non-conductive bus bars and bus bars that are only a temporary attachment for the purpose of the soldering operation.

Embodiments of the invention will now be described in more detail by way of example and with reference to the accompanying drawings, in which:

Figure 1 is a pictorial view of one end of the preferred embodiment of the present invention shown with heater pins mounted through holes in a printed circuit board.

Figure 2 is an exploded view of an end of the bus bar shown in Figure 1.

Figures 3A and B are detail views of one pin of the bus of Figures 1 and 2.

Figures 4A-C illustrate three different kinds of heating elements for use in the practice of the present invention.

Figure 5 is a detail cutaway of one end of a non-conductive frame embodiment of the present invention.

Figure 6 is a more general view of the non-conductive frame embodiment of Figure 5.

Figure 7 is a pictorial view of another embodiment of the present invention.

Figure 8 is a detail of one of the heater elements of the bus of Figure 7.

Figure 9 is a pictorial view of a further embodiment of the present invention.

Figure 10 is a detail of one of the heaters of the embodiment of Figure 9.

Figure 11 is an exploded view illustrating an embodiment in which a special solder preform carrier is employed.

Figure 12 is an end view of the embodiment of Figure 11 after joining.

Figure 13 is an assembly view of the bus of Figure 1 being mounted on a board by utilising another form of solder preform carrier.

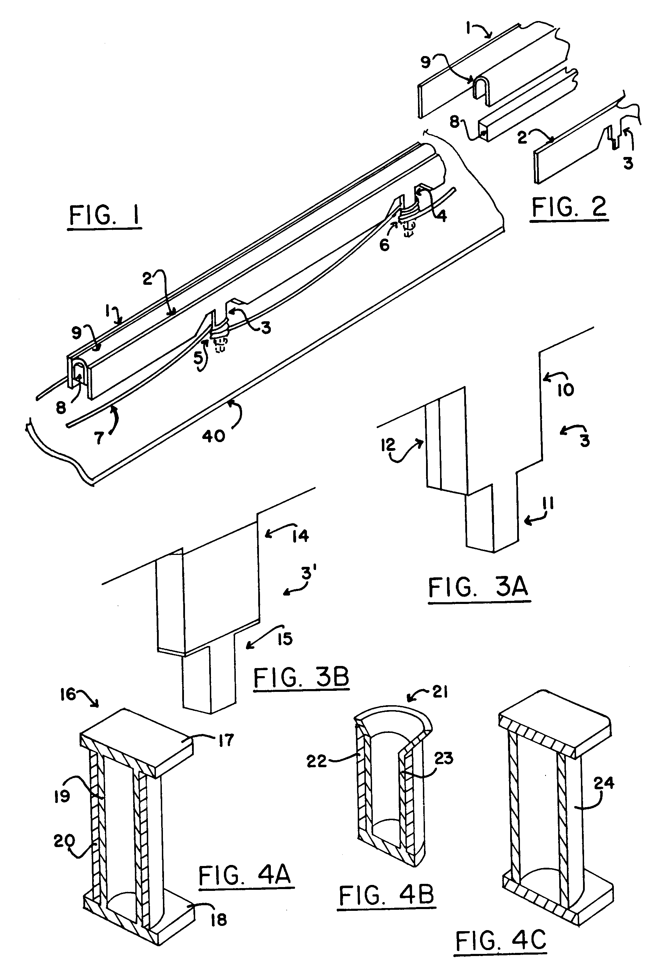

One embodiment of the present invention is shown in Figure 1 where the first body member 1 and second body member 2 of the bus bar are made of copper or other highly electrically conductive material as any standard current carrying bus would be. The pins 3 and 4 are comprised at least partially of a ferromagnetic material. Insulated wire 7 is wrapped around pins 3 and 4 to form coils 5 and 6. Stiffener 8 is held between body members 1 and 2 and insulated therefrom by insulator 9 as can be seen in Figure 2.

A high frequency alternating current is passed through coils 5 and 6 in series. The current in these coils 5 and 6 induces a flow of current in the ferromagnetic portion of the pins 3 and 4. The ferromagnetic portion may be a layer 12 as shown in Figure 3A or the entire pin 3' may be comprised of ferromagnetic material at its base 14 and/or tip 15 as shown in Figure 3B.

The current which is induced in the ferromagnetic layer generates heat as a function of the resistance of the ferromagnetic layer and the power supplied to the coil. Ferromagnetic materials such as carbon steel are characterised by their high resistance to current flow at low temperatures. This high resistance combined with the low mass of a thin ferromagnetic layer 12 or pin base 14 enables rapid heating of the pins 3 or 3'. Ferromagnetic materials are also characterised by a sudden drop in resistance about a temperature known as the Curie temperature. Therefore, once the pin 3 has reached the predetermined Curie temperature of the ferromagnetic material incorporated into the pin 3, the pin temperature will no longer rise because the quantity of resistive heating is drastically reduced.

The pins 3 and 4 have proximal ends that are integral with the bus bar and distal ends of reduced cross-section to form pin tips 11, 15 for soldering into holes in a base or circuit board 40. A typical pin tip 15 with cross-sectional dimensions of .035 inches (.089cm) by .035 inches (.089cm) and a length of .125 inches (.317cm) can achieve solder melt temperature before the bus bar reaches 120° C. A typical power density at the base of each pin of 1000 Watts/square inch (155 Watts/cm$^2$) yields sufficiently quick and concentrated heating to attain this temperature differential. The base of the pin being typically .150 x .140 inches (.381 x .356cm) on its broader face yields a power of 25 Watts/pin.

The thermal expansion of the bus body members 1 and 2 will depend on the change in temperature and the length of the bus. Assuming an ambient temperature of the bus of 76°F (24°C), a maximum temperature of 256°F (120°C) and a length of 4 inches (10.2cm) the thermal expansion would be:

$$(180°F) \, (.95 \times 10^{-5}) \, (4in) = .0068 \text{ inches (.17mm)}$$

The thermal expansion would be at least 8 times as great were the entire bus bar heated to solder melt temperature.

The temperature dependent resistance of the ferromagnetic heaters greatly increases their efficiency. Because of the greater electrical resistance of pins which are cooler and therefore need more heat, the power is used to generate more resistive heat where needed. The high power density combined with this self-regulating power distribution allows the pins to reach solder melt temperature in less than 10 seconds.

The high frequency power supply should operate in the range of 8 mHz to 20 mHz and should regulate at a substantially constant current about certain parameters known in the art.

Figures 4A-C illustrate different configurations and compositions for the pins or heating elements of different embodiments of the present invention. Figure 4A shows a heating element 16 with flat conductive ends 17 and 18 connected by a hollow conductive core 19. The core 19 is surrounded by ferromagnetic layer 20. The inductive coils would be wound around layer 20 when the heating element 16 is incorporated into a bus bar of the present invention.

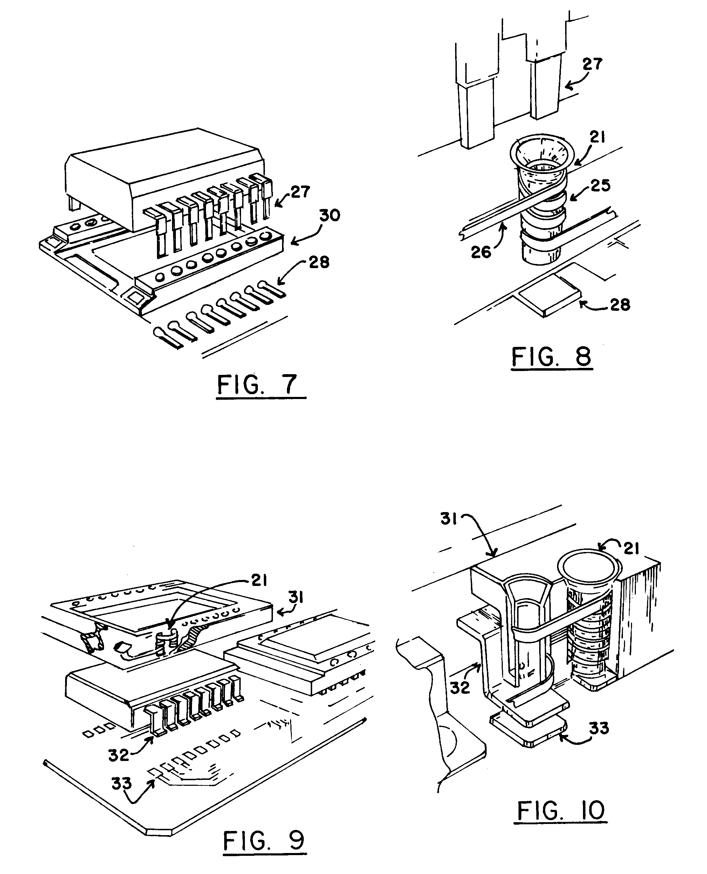

The element 21 of Figure 4B is similar in construction to element 16 in that a ferromagnetic layer 22 surrounds a conductive core 23. However, one end of element 21 is open for use in the embodiment of the present invention shown in Figures 7 and 8.

The operation of the heater elements where a highly conductive core is combined with a layer of ferromagnetic material (see pin 3, element 16 or element 21) can best be understood by reference to the United States patent to Carter and Krumme US-A-4,256,945. The conductive layer (10,19 or 23) assists in the autoregulation of the temperature by providing a path of low resistance for the alternating current once Curie temperature has been reached. As explained in the Carter and Krumme patent, until Curie temperature is reached the current flow is confined mainly to the ferromagnetic material by virtue of the "skin effect". Once Curie is reached, however, the current flows through the highly conductive material as well and therefore resistive heating is effectively cut off.

Figure 4C illustrates an embodiment where the ferromagnetic layer 24 does not surround a conductive layer. The heating element of Figure 4C is still wrapped by an inductance coil when incorporated into a bus bar.

Each of the heating element configurations illustrated in Figures 4A-C operates on the same heating/autoregulating principles described earlier.

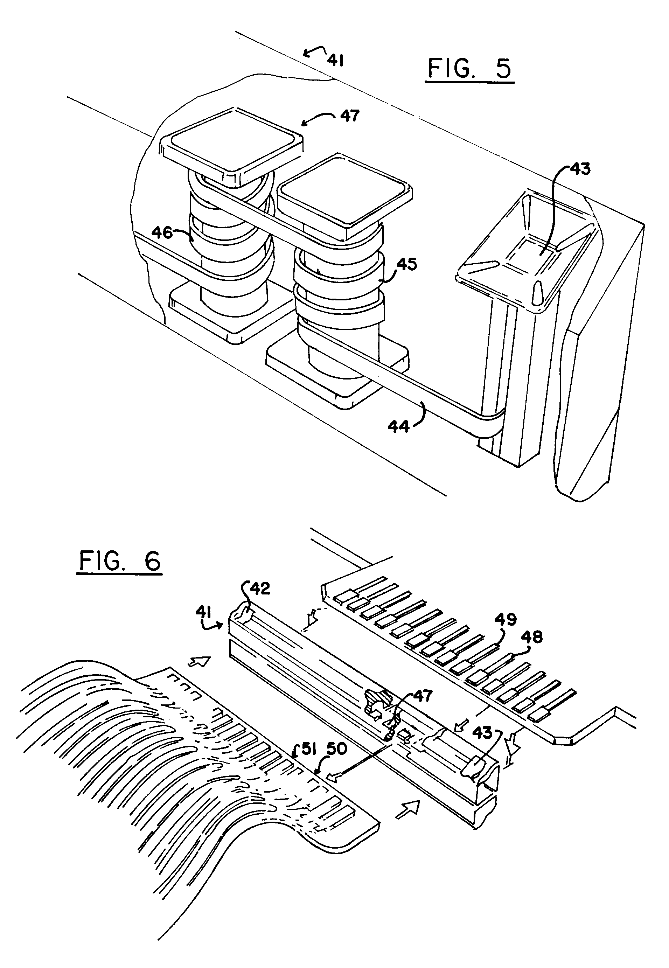

Figures 5 and 6 illustrate the arrangement of heaters in a bus bar with a non-conductive frame 41. Current is supplied to the bus bar at contact points 42 and 43. The high frequency alternating current travels along insulated wire 44 to coils 45 and 46. The alternating current in coils 45 and 46 induces current in the ferromagnetic portions of heaters 47. The induced current heats the heaters 47 to their Curie temperature.

Contacts 48 and 49 will each contact one flat end of heaters 47, respectively. Contacts 50 and 51 will contact the opposite flat ends of heaters 47, respectively. An amount of solder is disposed between each end of each heater 47 and the respective contact.

The Curie temperature of the heaters is above the melting point of the solder to be used. The heaters are energised long enough to form a bond between the heater end faces and the contacts.

Figures 7 and 8 illustrate the application of a heater 25 such as shown in Figure 4B. Contact is made to the exterior face of one end of the heater 21 by one contact 28 and contact is made to the internal surface of heater 21 by IC pin 27. Bus 30 carries a multiplicity of heaters 21 sufficient to accommodate the IC of the particular application.

Figures 9 and 10 illustrate an embodiment of the present invention where the bus 31 does not form part of the completed assembly. The bus 31 carries the heaters 21 which make temporary contact with the upper surfaces of IC pins 32. The solder is disposed between the lower surface of IC pin 32 and surface contact 33. The bus 31 and the heaters 21 which it carries simply supply the heat to the junction of 32 and 33 that is necessary to solder the two together.

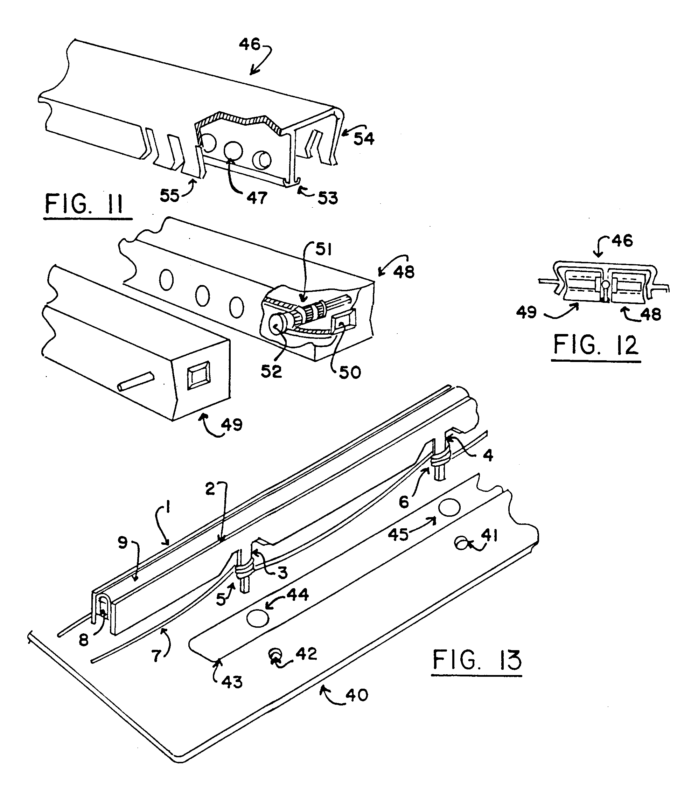

Due to rapid simultaneous heating of all of the pins or heating elements of the bus, solder cannot be applied in a conventional manner i.e. to each pin or element one at a time. The solder is therefore conveniently applied by means of a solder preform carrier. Two examples are shown at 43 in Figure 13 and 46 in Figures 11 and 12.

Figure 13 is an assembly view of the bus of Figure 1 just prior to mounting on printed circuit board 40. The solder carrier 43 is positioned between the bus pins 3 and 4 and the printed circuit board 40 so that solder and flux packets 44 and 45 are directly over holes 42 and 41, respectively. Packets 44 and 45 contain premeasured amounts of solder and flux needed to mount pins 3 and 4 into holes 42 and 41 of the printed circuit board 40. Preferably, the body of the solder carrier 43 is made to be flexible but without changing the fixed spacing distance of the packets of solder 44, 45.

The carrier 43 may be held in place on board 40 by a self-adhesive backing or by other suitable means. Bus pins 3 and 4 are placed against packets 44 and 45, respectively and a slight force is exerted towards urging pins 3 and 4 into holes 42 and 41.

Power is applied to coils 5 and 6 and pins 3 and 4 heat and melt the solder and flux of packets 44 and 45. Pins 3 and 4 drop into holes 42 and 41 under the urging pressure, and the now molten solder flows into the holes and surrounds the pins. The power is terminated, the pins 3 and 4 cool along with the solder and thusly the bus is mounted to the board 40.

Figure 11 illustrates a different embodiment of a solder preform carrier 46 to be used with other embodiments of the present invention. The carrier 46 carries packets of solder and flux 47 at fixed predetermined positions along the carrier centre bar 53. The centre bar 53 fits between two bus bars 48 and 49. One of the two bars could be a non-heating bus bar and all of the heat would be supplied by the one self-heating bus, or both busses could be self heating.

The solder packets 47 are positioned directly between opposing faces of heater elements such as face 52 and its opposing face (not shown). The busses are urged toward each other by arms 54 and 55 of the solder carrier 46. The heaters 51 are energised and the packets 47 melt and flow. Heating is terminated and the solder is allowed to cool while busses 48 and 49 are still being urged toward engagement. The finished assembly, as shown in Figure 12 includes the carrier 46 as part of the joint.

## Claims

1. An electrical terminal connection soldering assembly for making multiple soldered terminal connections in a row, comprising an elongated bus bar carrying a row of connector pins spaced along it which pins are oriented transversely to the longitudinal axis of the bus bar, characterised in that each connector pin in the row (3,4,16,21,25,40,47,51) is a self-contained heater including a ferromagnetic electrical resistance heating element (12,14 or 15, 20,22,24) and provided with its own respective electrical energising means (5,6;45,46) which produces a flow of heating current in the ferromagnetic heating element when connected to a substantially constant high frequency alternating current supply thereby to raise each heater pin to a sufficient temperature to melt solder which temperature is reached before the Curie temperature of the ferromagnetic material is effective to curtail further temperature increase.

2. An assembly according to Claim 1, wherein each of said heater pins comprises a core consisting at least in part of ferromagnetic material with a coil of an insulated current carrier wound about said core to induce a flow of current in the ferromagnetic material.

3. An assembly according to Claim 2, wherein the core of each heater pin comprises a ferromagnetic layer and a second layer (19,23) of high electrical and thermal conductivity contiguous with the ferromagnetic layer.

4. An assembly according to Claim 2 or Claim 3 wherein the heater pin coils are electrically connected in series to heat all the pins simultaneously.

5. An assembly according to any preceding claim wherein the bus bar body (1,2) is made of a highly electrically conductive material.

6. An assembly according to any of Claims 1 to 4, wherein the bus bar body (41) is made of a non-conductive material.

7. An assembly according to any preceding claim, wherein the heater pins (3,4) project at right angles to the longitudinal axis of the bus bar (1,2) and have proximal ends integral with the bus bar and distal ends (11,15) of reduced cross-section shaped to enter holes (41,42) in a circuit board (40).

8. An assembly according to any of Claims 1 to 6, wherein the heater pins (21) are disposed perpendicularly to the longitudinal axis of the bus bar (30) and are hollow with at least one open end.

9. An assembly according to any of Claims 1 to 6, wherein the heater pins (16,47) have flat electrically-conductive ends (17,18) for soldering or applying heat to respective electrical contacts.

10. An assembly according to any preceding claim, further comprising a solder preform carrier consisting of an elongate body (43,46) bearing in a row multiple discrete quantities of solder (44,45;47) at a spacing to suit the spacing distance of the heater pins of the bus bar.

11. An assembly according to Claim 10, wherein the body of the solder preform carrier is flexible, without change in the spacing of the quantities of solder.

12. A method for mounting a bus bar on a circuit board by connecting a row of pins along the bus bar to respective contacts on the board, characterised by:

forming the pins of said bus bar at least partly of a ferromagnetic material,

encircling each of said pins with a respective coil of an insulated current carrier,

electrically connecting said coils in circuit,

disposing respective amounts of solder in cooperative association with the distal ends of said pins and respective receptor holes in the circuit board,

applying pressure tending to urge said pins into said receptor holes,

energising said coils with a high frequency alternating electric current thereby to induce current flow in the ferromagnetic material of each pin sufficient to raise the temperature of the pins to solder melt temperature,

allowing the molten solder to flow into each receptor hole and around the respective pin as the pin enters the hole,

terminating the flow of current through the coils before the temperature of the main body of the bus bar is raised substantially, and

allowing the solder to cool and solidify.

**Patentansprüche**

1. Elektrische Lötanschlußverbindung zur Herstellung mehrerer gelöteter Klemmenverbindungen in einer Reihe, mit einer langgestreckten Busstange mit einer Reihe von in Längsrichtung im Abstand angeordneten Verbindungsstiften, welche quer zur Längsachse der Busstange orientiert sind, **dadurch gekennzeichnet**, daß jeder Verbindungsstift in der Reihe (3, 4, 16, 21, 25, 40, 47, 51) ein eigenständiger Heizer ist, der ein ferromagnetisches elektrisches Widerstandsheizelement (12, 14 oder 15, 20, 22, 24) ist, das mit jeweils eigenen elektrischen Speisemitteln (5, 6; 45, 46) versehen ist, die einen Fluß eines Heizstromes in dem ferromagnetischen Heizelement erzeugen, wenn es an eine im wesentlichen konstante, hochfrequente Wechselstromquelle angeschlossen ist, um so jeden Heizerstift auf eine ausreichende Temperatur anzuheben, um Lot zu schmelzen, wobei die Temperatur erreicht wird, bevor die Curie-Temperatur des ferromagnetischen Materials wirksam ist, um einen weiteren Temperaturanstieg zu verhindern.

2. Anordnung nach Anspruch 1, **dadurch gekennzeichnet**, daß jeder der genannten Heizerstifte einen Kern aufweist, der wenigstens teilweise aus ferromagnetischem Material besteht, mit einer Spule aus einem isolierten Stromleiter, der um den genannten Kern gewickelt ist, um einen Stromfluß in dem ferromagnetischen Material zu induzieren.

3. Anordnung nach Anspruch 2, **dadurch gekennzeichnet**, daß der Kern jedes Heizerstiftes eine ferromagnetische Schicht und eine zweite Schicht (19, 23) von hoher elektrischer und thermischer Leitfähigkeit, benachbart zu der ferromagnetischen Schicht, aufweist.

4. Anordnung nach einem der Ansprüche 2 oder 3, **dadurch gekennzeichnet**, daß die Heizerstiftspulen elektrisch in Reihe geschaltet sind, um alle Stifte gleichzeitig zu erwärmen.

5. Anordnung nach einem der vorhergehenden Ansprüche, **dadurch gekennzeichnet**, daß der Busstangenkörper (1, 2) aus einem elektrisch hochleitenden Material besteht.

6. Anordnung nach einem der Ansprüche 1 bis 4, **dadurch gekennzeichnet**, daß der Busstangenkörper (41) aus einem nichtleitenden Material besteht.

7. Anordnung nach einem der vorhergehenden Ansprüche, **dadurch gekennzeichnet**, daß die Heizerstifte (3, 4) in rechten Winkeln zu der Längsachse der Busstange (1, 2) vorstehen und proximale Enden haben, die mit der Busstange verbunden sind,und distale Enden (11, 15) von verringertem Querschnitt und von einer Form, daß sie in Löcher (41, 42) in einer Leiterplatte (40) einführbar sind.

8. Anordnung nach einem der Ansprüche 1 bis 6, **dadurch gekennzeichnet**, daß die Heizerstifte (21) senkrecht zu der Längsachse der Busstange (30) angeordnet und hohl sind, wobei wenigstens ein Ende offen ist.

9. Anordnung nach einem der Ansprüche 1 bis 6, **dadurch gekennzeichnet**, daß die Heizerstifte (16, 47) flache, elektrisch leitende Enden (17, 18) zum Löten oder Zuführen von Wärme zu den jeweiligen elektrischen Kontakten aufweisen.

10. Anordnung nach einem der vorhergehenden Ansprüche, **dadurch gekennzeichnet**, daß außerdem ein Lötvorformträger vorgesehen ist, der aus einem langgestreckten Körper (43, 46) besteht, der in einer Reihe viele diskrete Mengen von Lot (44, 45; 47) in einem Abstand entsprechend dem Abstand der Heizerstifte der Busstange birgt.

11. Anordnung nach Anspruch 10, **dadurch gekennzeichnet**, daß der Körper des Lötvorformträgers flexibel ist, ohne Veränderung im Abstand der Mengen von Lot.

12. Verfahren zur Anbringung einer Busstange an einer Leiterplatte durch Verbindung einer Reihe von Stiften entlang der Busstange mit zugehörigen Kontakten an der Platte, **gekennzeichnet durch**:

Herstellen der Stifte der genannten Busstange wenigstens teilweise aus einem ferromagnetischen Material,

Umschließen jedes der genannten Stifte mit einer zugehörigen Spule aus einem isolierten Stromleiter,

elektrisches Verbinden der genannten Spulen im Kreis,

Anbringen jeweiliger Mengen von Lot im Zusammenwirken mit den distalen Enden der genannten Stifte und zugehörigen Aufnahmelöchern in der Leiterplatte,

Anlegen von Druck, um die genannten Stifte in die Aufnahmelöcher zu drücken,

Speisung der Spulen mit einem hochfrequenten elektrischen Speisestrom, um so einen Stromfluß in dem ferromagnetischen Material jedes Stiftes zu induzieren, der ausreicht, um die Temperatur der Stifte auf die Lotschmelztemperatur anzuheben,

Einfließenlassen des geschmolzenen Lots in jedes Aufnahmeloch und rund um den zugehörigen Stift, wenn der Stift in das Loch eintritt,

Beenden des Stromflusses durch die Spulen, bevor die Temperatur des Hauptkörpers der Busstange wesentlich angehoben ist und

Abkühlen und Verfestigenlassen des Lotes.

**Revendications**

1. Dispositif de soudage pour connexion de bornes électriques pour réaliser des connexions multiples à bornes soudées en rangée, comprenant une barre omnibus allongée portant une rangée de plots de connexion espacés suivant sa longueur, les plots s'étendant transversalement à l'axe longitudinal de la barre omnibus, caractérisé en ce que chaque plot de connexion dans la rangée (3, 4 ,16, 21, 25, 40, 47, 51) est un dispositif chauffant indépendant comportant un élément chauffant à résistance électrique ferromagnétique (12, 14 ou 15, 20, 22, 24) et pourvu de son propre moyen d'excitation électrique respectif (5, 6; 45, 46) produisant une alimentation en courant de chauffage dans l'élément chauffant ferromagnétique lorsqu'il est connecté à une alimentation en courant alternatif à haute fréquence sensiblement constante de manière à augmenter la température de chaque plot formant dispositif chauffant jusqu'à une température suffisante pour faire fondre la soudure tendre, cette température étant atteinte avant que la température de Curie du matériau ferromagnétique ne puisse entraver une augmentation de température supplémentaire.

2. Dispositif suivant la revendication 1, dans lequel chaque plot formant dispositif chauffant comporte un noyau constitué au moins partiellement d'un matériau ferromagnétique, une bobine d'un conducteur de courant isolé étant enroulée autour de ce noyau afin d'induire un courant dans le matériau ferromagnétique.

3. Dispositif suivant la revendication 2, dans lequel le noyau de chaque plot formant dispositif chauffant comporte une couche ferromagnétique et une seconde couche (19, 23) présentant une conductivité électrique et thermique élevée contiguë à la couche ferromagnétique.

4. Dispositif suivant la revendication 2 ou 3, dans lequel les bobines de plots formant dispositifs chauffants sont électriquement connectées en série de manière à chauffer simultanément tous les plots.

5. Dispositif suivant l'une quelconque des revendications précédentes, dans lequel le corps (1, 2) de la barre omnibus est fabriquée en un matériau à conductivité électrique élevée.

6. Dispositif suivant l'une quelconque des revendications 1 à 4, dans lequel le corps (41) de la barre omnibus est fabriquée en un matériau non conducteur.

7. Dispositif suivant l'une quelconque des revendications précédentes, dans lequel les plots (3, 4) formant dispositifs chauffants font saillie selon des angles droits sur l'axe longitudinal de la barre omnibus (1, 2) et dans lequel les extrémités proximales des plots sont d'un seul tenant avec la barre omnibus, les extrémités distales (11, 15) ayant une section transversale réduite conformée pour pénétrer dans des trous (41, 42) ménagés dans une plaquette de circuits imprimés (40).

8. Dispositif suivant l'une quelconque des revendications 1 à 6, dans lequel les plots (21) formant dispositifs chauffants sont disposés perpendiculairement à l'axe longitudinal de la barre omnibus (30) et sont creux avec au moins une extrémité ouverte.

9. Dispositif suivant l'une quelconque des revendications 1 à 6, dans lequel les plots (16, 47) formant dispositifs chauffants comportent des extrémités plates (17, 18) conductrices de l'électricité pour le soudage ou l'application de chaleur aux contacts électriques respectifs.

10. Dispositif suivant l'une quelconque des revendications précédentes, comprenant en outre un support de préformage de soudure tendre constitué d'un corps allongé (43, 46) portant des quantités multiples séparées de soudure tendre (44, 45; 47) disposées dans une rangée selon un espacement adapté à la distance d'espacement des plots formant dispositifs chauffants de la barre omnibus.

11. Dispositif suivant la revendication 10, dans lequel le corps du support de préformage des soudures tendres est flexible, sans modifier l'espacement des quantités de soudure tendre.

12. Procédé pour monter une barre omnibus sur une plaquette de circuits imprimés en connectant une rangée de plots le long de la barre omnibus à des contacts respectifs sur la plaquette, caractérisé en ce qu'il comporte les phases consistant à :
   - former les plots de la barre omnibus au moins partiellement en un matériau ferromagnétique;
   - entourer chaque plot d'une bobine respective de conducteur de courant isolé:
   - connecter électriquement les bobines à un circuit;
   - disposer des quantités respectives de soudure tendre en association pour coopérative avec les extrémités distales des plots et avec les trous respectifs de réception ménagés dans la plaquette de circuits imprimés;
   - appliquer une pression destinée à solliciter les plots dans les trous de réception;
   - exciter les bobines par un courant alternatif électrique à haute fréquence de manière à induire un courant dans le matériau ferromagnétique de chaque plot, suffisant pour élever la température des plots jusqu'à la température de fusion de la soudure tendre;
   - permettre à la soudure fondue de couler dans chaque trou de réception et autour du plot respectif lorsque celui-ci pénètre dans le trou;
   - arrêter le courant à travers les bobines avant qu'une augmentation substantielle de la température du corps principal de la barre omnibus n'ait eu lieu, et
   - permettre à la soudure de refroidir et de solidifier.

FIG. 1

FIG. 2

FIG. 3A

FIG. 3B

FIG. 4A

FIG. 4B

FIG. 4C

FIG. 5

FIG. 6

FIG. 7

FIG. 8

FIG. 9

FIG. IO

FIG. 11

46

54

55    47    53

51    48

52    50

49

46

49    48

FIG. 12

FIG. 13

2

1

9

8    5    3    44

7    43    42    40

4

6

45    41